# EUROPÄISCHE PATENTSCHRIFT

(11) **EP 1 085 523 B1**
(45) Veröffentlichungstag und Bekanntmachung des Hinweises auf die Patenterteilung: **19.03.2008**
(21) Anmeldenummer: 00119563.5
(22) Anmeldetag: 07.09.2000
(51) Int. Cl.: G11C 29/00

(54) **Integrierter Speicher mit Speicherzellen und Referenzzellen**
Integrated memory with memory cells and reference cells
Mémoire integrée avec cellules de mémoire et cellules de référence

(30) Priorität: 14.09.1999 DE 19944037
(43) Veröffentlichungstag der Anmeldung: 21.03.2001
(73) Patentinhaber: Infineon Technologies AG, 81669 München (DE)
(72) Erfinder: Pöchmüller, Peter, 81739 München (DE)
(74) Vertreter: Epping - Hermann - Fischer

(56) Entgegenhaltungen:
- US-A- 5 023 839
- US-A- 5 163 021
- US-A- 5 265 056

## Beschreibung

Die Erfindung betrifft einen integrierten Speicher mit Speicherzellen, die in Kreuzungspunkten von Wortleitungen und Bitleitungen angeordnet sind, und mit Referenzzellen, die in Kreuzungspunkten einer Referenzwortleitung und den Bitleitungen angeordnet sind und die zur Erzeugung eines Referenzpotentials auf den Bitleitungen vor einem Auslesen der Speicherzellen dienen.

Ein solcher Speicher ist beispielsweise aus der US 5,163,021 bekannt, die einen EEPROM Speicher zeigt. Der einleitende Teil von Anspruch 1 basiert auf dieser Druckschrift.

Einen anderen derartigen integrierten Speicher in Form eines ferroelektrischen Speichers oder FRAMs (Ferroelectric Random Access Memory) ist in der US 5 844 832 A beschrieben. Die Referenzzellen werden vor einem Lesezugriff auf die Speicherzellen mit einem bestimmten Potential beschrieben und anschließend auf die Bitleitungen ausgelesen. Anschließend werden jeweils zwei benachbarte Bitleitungen, auf die Referenzzellen mit unterschiedlichen Pegeln ausgelesen wurden, miteinander kurzgeschlossen, so dass sich auf diesen beiden Bitleitungen ein Referenzpotential einstellt, das dem Mittelwert der beiden unterschiedlichen Pegel entspricht. Dabei sind die Referenzzellen identisch wie die normalen Speicherzellen aufgebaut. Vor jedem Auslesen der Speicherzellen, also beispielsweise auch während eines Tests der Speicherzellen, wird mittels der Referenzzellen auf die beschriebene Weise das Referenzpotential auf den Bitleitungen erzeugt, um mit den Bitleitungen verbundenen Leseverstärkern vor einer von diesen durchzuführenden Bewertung der Bitleitungspotentiale das definierte Referenzpotential zuzuführen.

Fehler beim Auslesen einer der Speicherzellen beim so eben beschriebenen Speicher können zweierlei unterschiedliche Ursachen haben. Zum einen kann die gerade auszulesende Speicherzelle bzw. die mit ihr verbundene Wortleitung einen Defekt aufweisen. Zum anderen kann ein Defekt der zugehörigen Referenzzelle vorliegen, so daß das Referenzpotential nicht in korrekter Weise erzeugt wird, wodurch eine fehlerfreie Bewertung des Bitleitungspotentials durch die Leseverstärker verhindert wird. Es ist daher wünschenswert, feststellen zu können, ob ein auftretender Fehler beim Auslesen einer der Speicherzellen durch eine Fehlfunktion der Referenzzellen bedingt ist oder nicht.

Der Erfindung liegt daher die Aufgabe zugrunde, einen integrierten Speicher der eingangs beschriebenen Art anzugeben, bei dem eine Prüfung der Funktionsfähigkeit der Referenzzellen auf einfache Weise erfolgt.

Diese Aufgabe wird mit einem integrierten Speicher gemäß Anspruch 1 gelöst. Vorteilhafte Aus- und Weiterbildungen der Erfindung sind Gegenstand der abhängigen Ansprüche.

Der erfindungsgemäße Speicher weist Speicherzellen auf, die in Kreuzungspunkten von Wortleitungen und Bitleitungen angeordnet sind, und erste Referenzellen, die in Kreuzungspunkten wenigstens einer ersten Referenzwortleitung und den Bitleitungen angeordnet sind und die in einer Normalbetriebsart zur Erzeugung eines Referenzpotentials auf den Bitleitungen vor einem Auslesen der Speicherzellen dienen. Außerdem weist er zweite Referenzellen auf, die in Kreuzungspunkten wenigstens einer zweiten Referenzwortleitung und den Bitleitungen angeordnet sind und die in einer Testbetriebsart zur Erzeugung eines Referenzpotentials auf den Bitleitungen vor einem Auslesen der ersten Referenzzellen dienen.

Die zweiten Referenzzellen ermöglichen also eine Funktionsüberprüfung der ersten Referenzzellen in der Testbetriebsart, in dem mit ihrer Hilfe ein entsprechendes Referenztpotential auf den Bitleitungen erzeugt wird. Somit können die ersten Referenzzellen in der Testbetriebsart auf die gleiche Weise ausgelesen werden, wie dies mit den normalen Speicherzellen in der Normalbetriebsart erfolgt. Sofern ein Fehler der zweiten Referenzzellen ausgeschlossen werden kann, kann bei Auftreten einer Funktionsstörung beim Auslesen einer der ersten Referenzzellen gefolgert werden, daß ein Defekt der ersten Referenzzelle vorliegt. Ist dagegen nicht bekannt, ob die zweiten Referenzzellen intakt sind, und wird beim Auslesen einer der ersten Referenzzellen in der Testbetriebsart ein Fehler festgestellt, steht fest, daß entweder die entsprechende erste Referenzzelle oder die zur Erzeugung des Referenzpotentials benutzten zweiten Referenzzellen einen Defekt aufweisen.

Entsprechend der Erfindung weist der Speicher Adresseingänge zur Zuführung von Zeilenadressen auf, über die die Wortleitungen adressierbar sind. Außerdem weist er einen Zeilendecoder auf, über den die zweite Referenzwortleitung in der Normalbetriebsart mittels einer bestimmten der Zeilenadressen adressierbar ist und über den die erste Referenzwortleitung in der Testbetriebsart mittels der bestimmten Zeilenadresse adressierbar ist. Dies ermöglicht eine Adressierung der ersten Referenzwortleitung in der Testbetriebsart auf die gleiche Weise, in der in der Normalbetriebsart die Adressierung einer beliebigen der Wortleitungen erfolgt.

Nach einer vorteilhaften Weiterbildung der Erfindung ist die wenigstens eine zweite Referenzwortleitung identisch mit einer der Wortleitungen und die zweiten Referenzzellen sind identisch mit den an diese Wortleitung angeschlossenen Speicherzellen. Das bedeutet, daß in der Normalbetriebsart die ersten Referenzzellen zur Erzeugung des Referenzpotentials vor einem Auslesen einer der normalen Speicherzellen dienen, während in der Testbetriebsart die normalen Speicherzellen der zweiten Referenzwortleitung zum Erzeugen des Referenzpotentials vor einem Auslesen einer der ersten Referenzzellen dienen. Bei dieser Weiterbildung sind zusätzlich zu den normalen Speicherzellen und ersten Referenzzellen keine weiteren Zellen notwendig, so das ein derartiger Speicher mit einer vergleichsweise kleinen Fläche realisiert werden kann.

Nach einer anderen Weiterbildung der Erfindung weist der Speicher mehrere zweite Referenzwortleitungen auf sowie einen Steuereingang zur Zuführung eines Steuersignals, über das eine Auswahl wenigstens einer der zweiten Referenzwortleitungen erfolgt, deren zweite Referenzzellen anschließend in der Testbetriebsart vor einem Auslesen der ersten Referenzzellen zur Erzeugung des Referenzpotentials auf den Bitleitungen dienen. Bei dieser Weiterbildung kann in der Testbetriebsart ein mehrfaches Auslesen einer der ersten Referenzzellen erfolgen, bei dem das notwendige Referenzpotential auf den Bitleitungen nacheinander jeweils mit unterschiedlichen der zweiten Referenzzellen erzeugt wird. Daher kann festgestellt werden, ob das Auftreten eines Defekts während des Auslesens auf eine Fehlfunktion der entsprechenden ersten Referenzzelle oder der zweiten Referenzzelle zurückzuführen ist. Ist nämlich die erste Referenzzelle defekt, wird sich bei ihrem Auslesen, unabhängig von der jeweils verwendeten zweiten Referenzzelle, immer ein falsches Ergebnis ergeben. Dagegen ist es unwahrscheinlich, daß mehrere zweite Referenzzellen, die unterschiedlichen zweiten Referenzwortleitungen zugeordnet sind, gleichzeitig defekt sind.

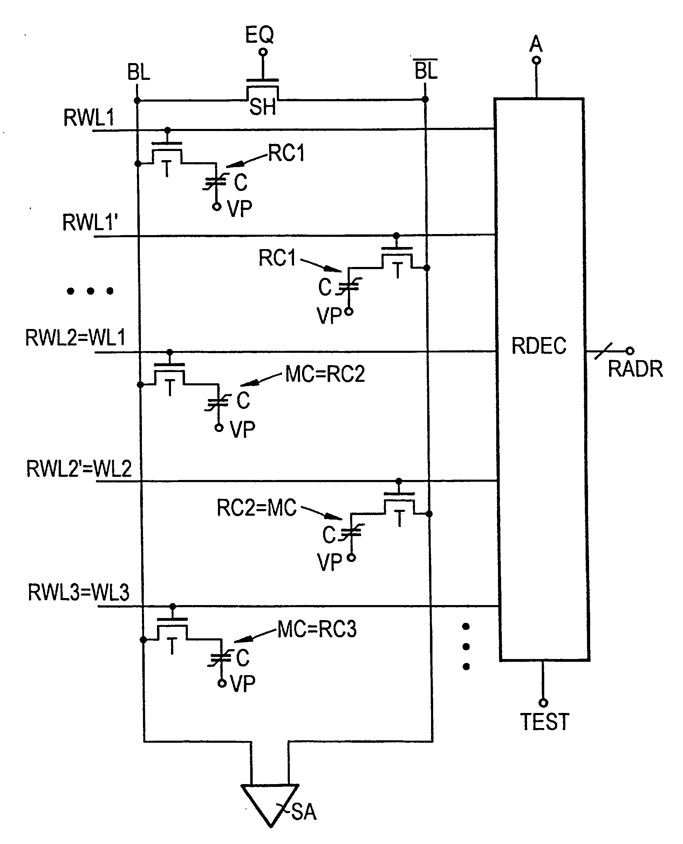

Die Erfindung wird im folgenden anhand der Figur näher beschrieben, die ein Ausführungsbeispiel des integrierten Speichers zeigt.

Die Figur zeigt einen Ausschnitt eines Speicherzellenfeldes eines integrierten Speichers vom Typ FRAM. Dargestellt ist ein Bitleitungspaar BL, /BL, das mit einem Leseverstärker SA verbunden ist. Der Speicher weist erste Referenzwortleitungen RWL1, RWL1' sowie Wortleitungen WLi auf, von denen eine große Anzahl vorhanden ist, in der Figur jedoch nur drei dargestellt sind. In Schnittpunkten der Wortleitungen WLi mit den Bitleitungen BL, /BL befinden sich normale Speicherzellen MC und in Schnittpunkten der ersten Referenzleitungen RWL1, RWL1' mit den Bitleitungen befinden sich erste Referenzzellen RC1. Die Speicherzellen MC und ersten Referenzzellen RC1 sind identisch aufgebaut. Jede von ihnen weist einen Speicherkondensator C mit ferroelektrischem Dielektrikum und einen Auswahltransistor T auf. Eine der Elektroden der Speicherkondensatoren C ist mit einem Plattenpotential VP und die andere Elektrode über die steuerbare Strecke des Auswahltransistors T mit der entsprechenden Bitleitung BL, /BL verbunden. Das Gate des Auswahltransistors T ist mit der entsprechenden Wortleitung WLi bzw. Referenzwortleitung RWL1, RWL 1' verbunden.

Die beiden Bitleitungen BL, /BL sind über einen Kurzschlußtransistor SH miteinander verbunden. Das Gate des Kurzschlußtransistors SH ist mit einem Kurzschlußsignal EQ verbunden. Weiterhin weist der Speicher einen Zeilendecoder RDEC auf, dem Zeilenadressen RADR zuführbar sind, über die die Wortleitungen WLi in einer Normalbetriebsart des Speichers adressierbar sind. Dem Zeilendecoder RDEC wird ein Betriebsartsignal TEST zugeführt, welches angibt, ob sich der Speicher in der Normalbetriebsart oder in einer Testbetriebsart befindet. Außerdem wird dem Zeilendecoder RDEC ein Steuersignal A zugeführt.

Die Funktionsweise der in der Figur dargestellten Schaltung bei einem Lesezugriff auf eine der Speicherzellen MC ist folgende: vor dem Lesezugriff wird zunächst in einer der beiden ersten Referenzzellen RC1 eine logische 0 und in der anderen eine logische 1 gespeichert. Anschließend werden die beiden Bitleitungen BL, /BL entladen und daraufhin werden die beiden ersten Referenzzellen auf die Bitleitungen ausgelesen. Dabei ist zunächst der Kurzschlußtransistor SH gesperrt und der Leseverstärker SA inaktiv. Dann wird der Kurzschlußtransistor SH leitend geschaltet, so daß ein Ladungsausgleich zwischen den beiden Bitleitungen stattfindet. Es stellt sich dabei auf beiden Bitleitungen BL, /BL ein Referenzpotential ein, das in etwa dem Mittelwert der beiden sich zuvor auf den Bitleitungen einstellenden Potentiale entspricht. Nun wird der Kurzschlußtransistor SH wieder gesperrt. Erst dann erfolgt durch Aktivierung einer der Wortleitungen WLi die Auswahl einer der Speicherzellen MC in Abhängigkeit der dem Zeilendecoder RDEC zugeführten Zeilenadresse RADR. Beispielsweise wird die Wortleitung WL1 aktiviert, so daß der Inhalt der mit ihr verbundenen Speicherzelle MC auf die linke Bitleitung BL ausgelesen wird. Dann wird der Leseverstärker SA aktiviert, der die Potentialdifferenz zwischen den beiden Bitleitungen verstärkt. Hierbei erfolgt eine Bewertung des Potentials der linken Bitleitung BL gegenüber dem noch immer auf der rechten Bitleitung /BL vorhandenen Referenzpotential.

In der Testbetriebsart erfolgt eine Überprüfung der Funktionsfähigkeit der ersten Referenzzellen RC1. Dies geschieht durch Einschreiben eines Datums in die ersten Referenzzellen und anschließendes Wiederauslesen. Da der Leseverstärker SA auch hierbei für eine korrekte Bewertung das Referenzpotential benötigt, wird dieses in der Testbetriebsart mittels zweier der normalen Speicherzellen MC erzeugt. Bei diesem Ausführungsbeispiel sind die erste Wortleitung WL1 und die zweite Wortleitung WL2 zweite Referenzwortleitungen RWL2, RWL2' und die mit ihnen verbundenen Speicherzellen MC sind zweite Referenzzellen RC2. Die zweiten Referenzzellen RC2 dienen in der Testbetriebsart zur Erzeugung des Referenzpotentials auf den Bitleitungen BL, /BL, wie die ersten Referenzzellen RC1 in der Normalbetriebsart. Daher wird in der Testbetriebsart vor einem Zugriff auf eine der ersten Referenzzellen RC1 ein erster logischer Pegel in die mit der ersten Wortleitung WL1 verbundene zweite Referenzzelle RC2 und ein zweiter logischer Pegel in die mit der zweiten Wortleitung WL2 verbundene zweite Refernzzelle RC2 eingeschrieben. Nach einem Entladen der Bitleitungen erfolgt ein Auslesen der beiden Informationen und ein nachfolgendes Kurzschließen mittels des Kurzschlußtransistors SH, wodurch das Referenzpotential erzeugt wird. Anschließend kann durch Aktivierung einer der beiden ersten Referenzwortleitungen RWL1, RWL1' ein zuvor eingeschriebenes Datum aus einer der beiden ersten Referenzzellen RC1 ausgelesen werden. Der Leseverstärker SA wird daraufhin aktiviert und nimmt eine Bewertung der Potentialdifferenz auf dem Bitleitungspaar BL, /BL vor.

Der Speicher dieses Ausführungsbeispiels weist noch weitere Paare von zweiten Referenzwortleitungen auf, die gleichfalls durch jeweils zwei der normalen Wortleitungen WLi gebildet sind. Von diesen ist in der Figur lediglich eine weitere zweite Referenzwortleitung RWL3 eingezeichnet. Es ist zu beachten, daß der Speicher eine wesentlich größere Anzahl von normalen Wortleitungen WLi aufweist, die, anders als die in der Figur dargestellten, keine Doppelfunktion ausüben, also nicht gleichzeitig auch zwei weitere Referenzwortleitungen sind. In der Testbetriebsart kann ein beliebiges der Paare von zweiten Referenzwortleitungen RWL2, RWL2', RWL3 vor einem Auslesen einer der ersten Referenzzellen RC1 zum Erzeugen des Referenzpotentials auf den Bitleitungen BL, /BL dienen. Es kann auch beispielsweise die untere zweite Referenzwortleitung RWL3 zur Erzeugung des Referenzpotentials anstelle der oberen zweiten Referenzwortleitung RWL2 eingesetzt werden, gemeinsam mit der mittleren Referenzwortleitung RWL2'. Somit kann die korrekte Erzeugung des Referenzpotentials in der Testbetriebsart auch erfolgen, wenn die erste Wortleitung WL1 bzw. die mit ihr verbundene Speicherzelle MC einen Defekt aufweist. Das Steuersignal A ist ein digitales Steuersignal mit mehreren Bit Breite. Es dient zur Auswahl zweier der zweiten Referenzwortleitungen RWL2, RWL2', RWL3 zur Erzeugung des Referenzpotentials auf den Bitleitungen in der Testbetriebsart.

Bei anderen Ausführungsbeispielen der Erfindung können auch lediglich zwei zweite Referenzwortleitungen RWL2, RWL2' vorhanden sein.

Wenn in der Testbetriebsart das Referenzpotential mittels der ersten Wortleitung WL1 und der zweiten Wortleitung WL2 als zweite Referenzwortleitungen RWL2, RWL2' erzeugt wird, erfolgt bei diesem Ausführungsbeispiel der Erfindung die nachfolgende Ansteuerung der ersten Referenzwortleitungen RWL1, RWL1' mittels derjenigen Zeilenadressen RADR, die in der Normalbetriebsart der ersten Wortleitung WL1 bzw. der zweiten Wortleitung WL2 zugeordnet sind. Dies ermöglicht einen Betrieb des Speichers in der Testbetriebsart in gleicher Weise wie in der Normalbetriebsart, nur daß in der letzteren die ersten Referenzzellen RC1 zur Erzeugung des Referenzpotentials beim Auslesen einer der Speicherzellen MC dienen und in der ersteren die zweiten Referenzzellen RC2 zum Erzeugen des Referenzpotentials einer beliebigen anderen Speicherzelle MC und der ersten Referenzzellen RC1 dienen.

Der in der Figur ausschnittsweise dargestellte Speicher weist Bitleitungen nach dem Folded-Bitline-Konzept auf. Die Erfindung ist selbstverständlich auch auf Speicher mit anderer Bitleitungsarchitektur, insbesondere solchen nach dem Open-Bitline-Konzept, wie es beispielsweise in der eingangs erwähnten US 5 844 832 A dargestellt ist, anwendbar.

Obwohl die Erfindung hier beispielhaft anhand eines FRAMs erläutert wurde, ist sie auch auf andere Speicher anwendbar, bei denen auf den Bitleitungen vor dem Auslesen von Speicherzellen entsprechende Referenzpotentiale erzeugt werden müssen.

Obwohl bei dem hier geschilderten Ausführungsbeispiel einige der Wortleitungen WLi mit den zweiten Referenzwortleitungen RWL2, RWL2', RWL3 identisch sind, ist es bei anderen Ausführungsbeispielen möglich, das die zweiten Referenzwortleitungen zusätzlich zu den normalen Wortleitungen WLi vorhanden sind.

Bei dem in der Figur gezeigten Ausführungsbeispiel sind die ersten Referenzzellen RC1 mit unterschiedlichen ersten Referenzwortleitungen RWL1, RWL1' verbunden. Außerdem sind die zweiten Referenzzellen RC2 mit unterschiedlichen zweiten Referenzwortleitungen RWL2, RWL2' verbunden. Es sind andere Ausführungsbeispiele möglich, bei dem beide erste Referenzzellen RC1 mit einer gemeinsamen ersten Referenzwortleitung RWL1 und beide zweite Referenzzellen RC2 mit einer gemeinsamen zweiten Referenzwortleitung RWL2 verbunden sind.

## Patentansprüche

1. Integrierter Speicher
- mit Speicherzellen (MC), die in Kreuzungspunkten von Wortleitungen (WLi) und Bitleitungen (BL, /BL) angeordnet sind,
- mit ersten Referenzzellen (RC1), die in Kreuzungspunkten wenigstens einer ersten Referenzwortleitung (RWL1, RWL1') und den Bitleitungen (BL, /BL) angeordnet sind und die in einer Normalbetriebsart zur Erzeugung eines Referenzpotentials auf den Bitleitungen vor einem Auslesen der Speicherzellen (MC) dienen,
- mit zweiten Referenzzellen (RC2, RC3), die in Kreuzungspunkten wenigstens einer zweiten Referenzwortleitung (RWL2, RWL2', RWL3) und den Bitleitungen (BL, /BL) angeordnet sind und die in einer Testbetriebsart zur Erzeugung eines Referenzpotentials auf den Bitleitungen vor einem Auslesen der ersten Referenzzellen (RC1) dienen,
- mit Adreßeingängen zur Zuführung von Zeilenadressen (RADR) zur Adressierung der Wortleitungen (WLi),
- **gekennzeichnet durch** einen Zeilendecoder (RDEC),
- über den die zweite Referenzwortleitung (RWL2, RWL2', RWL3) in der Normalbetriebsart mittels einer bestimmten der Zeilenadressen (RADR) adressierbar ist
- und über den die erste Referenzwortleitung (RWL1, RWL1') in der Testbetriebsart mittels der bestimmten Zeilenadresse (RADR) adressierbar ist.

2. Integrierter Speicher nach Anspruch 1,
dessen zweite Referenzwortleitung (RWL2, RWL2', RWL3) identisch mit einer der Wortleitungen (WL1, WL2) ist und dessen zweite Referenzzellen (RC2, RC3) identisch mit den an diese Wortleitung angeschlossenen Speicherzellen (MC) sind.

3. Integrierter Speicher nach einem der vorstehenden Ansprüche,
- mit mehreren zweiten Referenzwortleitungen (RWL2, RWL2', RWL3),
- und mit einem Steuereingang zur Zuführung eines Steuersignals (A), über das eine Auswahl wenigstens einer der zweiten Referenzwortleitungen erfolgt, deren zweite Referenzzellen (RC2, RC3) anschließend in der Testbetriebsart vor einem Auslesen der ersten Referenzzellen (RC1) zur Erzeugung des Referenzpotentials auf den Bitleitungen (BL, /BL) dienen.

## Claims

1. Integrated memory
- having memory cells (MC), which are arranged at crossover points of word lines (WLi) and bit lines (BL, /BL),
- having first reference cells (RC1), which are arranged at crossover points of at least one first reference word line (RWL1, RWL1') and the bit lines (BL, /BL) and, in a normal operating mode, serve for generating a reference potential on the bit lines prior to a readout of the memory cells (MC),
- having second reference cells (RC2, RC3), which are arranged at crossover points of at least one second reference word line (RWL2, RWL2', RWL3) and the bit lines (BL, /BL) and, in a test operating mode, serve for generating a reference potential on the bit lines prior to a readout of the first reference cells (RC1),
- having address inputs for feeding row addresses (RADR) for addressing the word lines (WLi),
- **characterized by** a row decoder (RDEC),
- via which the second reference word line (RWL2, RWL2', RWL3) can be addressed by means of a specific one of the row addresses (RADR) in the normal operating mode
- and via which the first reference word line (RWL1, RWL1') can be addressed by means of the specific row address (RADR) in the test operating mode.

2. Integrated memory according to Claim 1,
whose second reference word line (RWL2, RWL2', RWL3) is identical to one of the word lines (WL1, WL2) and whose second reference cells (RC2, RC3) are identical to the memory cells (MC) connected to said word line.

3. Integrated memory according to one of the preceding claims,
- having a plurality of second reference word lines (RWL2, RWL2', RWL3),
- and having a control input for feeding a control signal (A), which is used to effect selection of at least one of the second reference word lines, whose second reference cells (RC2, RC3) subsequently serve for generating the reference potential on the bit lines (BL, /BL) in the test operating mode prior to a readout of the first reference cells (RC1).

## Revendications

1. Mémoire intégrée
- comprenant des cellules (MC) de mémoire, qui sont disposées aux points d'intersection de lignes (WLi) de mots et de lignes (BL, /BL) de bits,
- comprenant des premières cellules (RC1) de référence, qui sont disposées aux points d'intersection d'au moins une première ligne (RWL1, RWL1') de mots de référence et des lignes (BL, /BL) de bits et qui, dans un type de fonctionnement normal, servent à produire un potentiel de référence sur les lignes de bits avant une lecture des cellules (MC) de mémoire,
- comprenant des deuxièmes cellules (RC2, RC3) de référence, qui sont disposées aux points d'intersection d'au moins une deuxième ligne (RWL2, RWL2', RWL3) de mots de référence et des lignes (BL, /BL) de bits et qui, dans un type de fonctionnement de test, servent à produire un potentiel de référence sur les lignes de bits avant une lecture des premières cellules (RC1) de référence,
- comprenant des entrées d'adresse pour envoyer des adresses (RADR) de lignes pour l'adressage de lignes (WLi) de mots,
- comprenant un décodeur (RDEC) de lignes,
- par lequel la deuxième ligne (RWL2, RWL2', RWL3) de mots de référence peut, dans le type de fonctionnement normal, être adressée au moyen de l'une déterminée des adresses (RADR) de lignes
- et par lequel la première ligne (RWL1, RWL1') de mots de référence peut, dans le type de fonctionnement de test, être adressée au moyen des adresses (RADR) de lignes déterminées.

2. Mémoire intégrée suivant la revendication 1,
dont la deuxième ligne (RWL2, RWL2', RWL3) de mots de référence est identique à l'une des lignes (WL1, WL2) de mots et dont les deuxièmes cellules (RC2, RC3) de référence sont identiques aux cellules (MC) de mémoire raccordées à cette ligne de mots.

3. Mémoire intégrée suivant l'une des revendications précédentes,
- comprenant plusieurs deuxièmes lignes (RWL2, RWL2', RWL3) de mots de référence,
- et comprenant une entrée de commande pour envoyer un signal (A) de commande par lequel un choix d'au moins l'une des deux lignes de mots dans les deuxièmes cellules (RC2, RC3) de référence servent ensuite, dans le type de fonctionnement de test avant une lecture des premières cellules (RC1) de référence, à produire le potentiel de référence sur les lignes (BL, /BL) de bits.
